(19) Europäisches Patentamt
European Patent Office
Office européen des brevets

(11) **EP 4 701 087 A1**

(12) **EUROPEAN PATENT APPLICATION**
published in accordance with Art. 153(4) EPC

(43) Date of publication:
**25.02.2026 Bulletin 2026/09**

(21) Application number: **24937447.1**

(22) Date of filing: **30.04.2024**

(51) International Patent Classification (IPC):
**H03M 1/18** (2006.01)

(52) Cooperative Patent Classification (CPC):
**H03M 1/06; H03M 1/12; H03M 1/18**

(86) International application number:
**PCT/CN2024/091035**

(87) International publication number:
**WO 2025/227403 (06.11.2025 Gazette 2025/45)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Shenzhen Hollyland Technology Co.,
Ltd.
Shenzhen, Guangdong 518108 (CN)**

(72) Inventors:
• LIU, Dezhi
  **Shenzhen, Guangdong 518108 (CN)**
• WEI, Hong
  **Shenzhen, Guangdong 518108 (CN)**

(74) Representative: **Grünecker Patent- und
Rechtsanwälte
PartG mbB
Leopoldstraße 4
80802 München (DE)**

(54) **ANALOG-TO-DIGITAL CONVERSION APPARATUS AND AUDIO APPARATUS**

(57)     Provided in the present application are an analog-to-digital conversion apparatus and an audio apparatus. The analog-to-digital conversion apparatus comprises a shunting module, at least two branches and a sound mixing module. A first branch comprises a first gain processing module and a first analog-to-digital conversion module which are cascaded, and a second branch comprises a second gain processing module and a second analog-to-digital conversion module which are cascaded. In the present application, an analog signal is outputted to two branches by means of a shunting module, the two branches are provided with different gains, and a sound mixing module adjusts the amplitudes of digital signals received from the two branches so as to minimize the amplitude difference between the two digital signals, thereby ensuring that the digital signal outputted by at least one branch remains undistorted, and also ensuring that a combined digital signal remains undistorted; and since an undistorted digital signal can be outputted without the need for an additional gain adjustment module, the problem of a gain adjustment module requiring a certain amount of time to adjust a gain, potentially leading to poor signal quality before the adjustment is completed is solved.

FIG. 2

# Description

TECHNICAL FIELD

The present application relates to signal processing technologies, and in particular, to an analog-to-digital conversion device and an audio device.

BACKGROUND

An analog-to-digital conversion device is mainly used to convert an analog signal into a digital signal. During the conversion process, gain processing of the signal is usually required to avoid signal distortion.

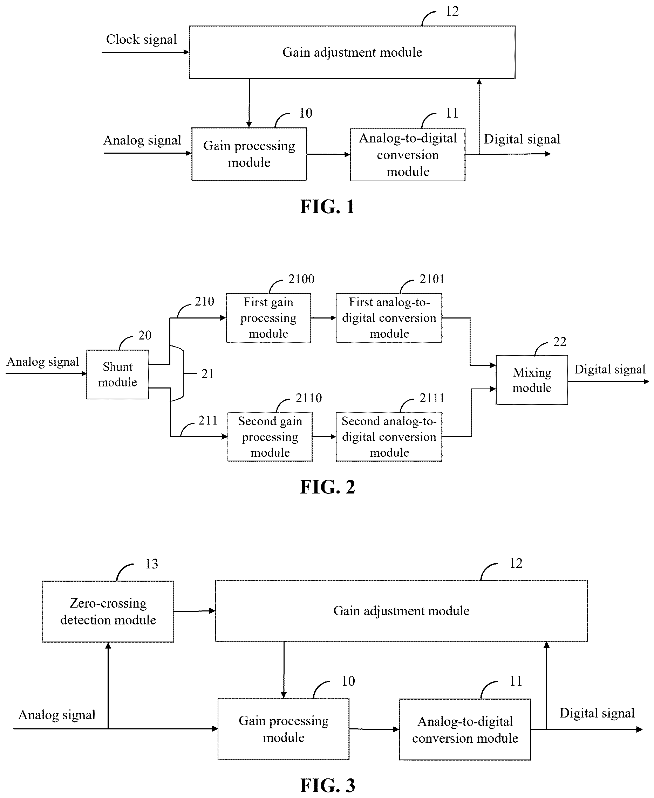

For an analog-to-digital conversion device in the related art, as shown in FIG. 1, one link of the analog-to-digital conversion device includes a gain processing module 10 and an analog-to-digital conversion module 11 cascaded together. In this link, an analog signal is amplified and then converted into a digital signal. The other link includes a gain adjustment module 12, which periodically adjusts the gain of the gain processing module by receiving clock signals.

Since this type of analog-to-digital conversion device can only adjust the gain of the gain processing module 10 periodically, for example, the gain adjustment module 12 can only readjust the gain of the gain processing module 10 in the (T+1)-th clock cycle based on the digital signal output by the gain processing module 10 and received in the T-th clock cycle, it is impossible to adjust the gain of the gain processing module 10 in a timely manner within one cycle. In cases such as analog signal oscillation or distortion, the gain cannot be adjusted promptly to ensure the quality of the output signal. Especially in scenarios sensitive to the quality of audio signals, the user experience is seriously affected.

SUMMARY

In view of this, embodiments of the present application propose an analog-to-digital conversion device and an audio device to solve the technical problems in the related art.

According to a first aspect of the embodiments of the present application, an analog-to-digital conversion device is proposed. The analog-to-digital conversion device includes a shunt module, at least two branches and a mixing module, where a first branch includes a first gain processing module and a first analog-to-digital conversion module connected in cascade, and a second branch includes a second gain processing module and a second analog-to-digital conversion module connected in cascade;

the shunt module is configured to split a received analog signal into two paths of analog signals and output the two paths of analog signals to the first branch and the second branch respectively;

the first gain processing module is configured to scale a received analog signal according to a first gain and output the scaled analog signal to the first analog-to-digital conversion module;

the second gain processing module is configured to scale a received analog signal according to a second gain and output the scaled analog signal to the second analog-to-digital conversion module; where a difference between the first gain and the second gain is not greater than a first preset value;

the first analog-to-digital conversion module or the second analog-to-digital conversion module is configured to convert a received analog signal after gain processing into a digital signal and output the digital signal to the mixing module; and

the mixing module is configured to adjust amplitudes of digital signals received from the first branch and the second branch, so that a difference between amplitudes of two paths of adjusted digital signals is not greater than a second preset value, and merge the two paths of adjusted digital signals into one path of digital signal for output.

According to a second aspect of the embodiments of the present application, an audio device is proposed. The audio device includes: an audio acquisition module and an analog-to-digital conversion device;

the audio acquisition module is configured to output an acquired analog audio signal to the analog-to-digital conversion device;

the analog-to-digital conversion device includes a shunt circuit, at least two branches and a programmable logic chip, where a first branch includes a first gain amplifier and a first analog-to-digital converter connected in cascade, and a second branch includes a second gain amplifier and a second analog-to-digital converter connected in cascade;

the shunt circuit is configured to split a received analog signal into two paths of analog signals and output the two paths of analog signals to the first branch and the second branch respectively;

the first gain amplifier is configured to scale a received analog signal according to a predetermined gain and output the scaled analog signal to the first analog-to-digital converter;

the second gain amplifier is configured to scale a received analog signal according to a predetermined gain and output the scaled analog signal to the second analog-to-digital converter; where the predetermined gain of the first gain amplifier is different from the predetermined gain of the second gain amplifier;

the first analog-to-digital converter or the second analog-to-digital converter is configured to convert a received analog signal after gain processing into a digital signal and output the digital signal to the programmable logic chip; and

the programmable logic chip is configured to adjust amplitudes of digital signals received from the first branch and the second branch, so that a difference between amplitudes of two paths of adjusted digital signals is not greater than a preset value, and merge the two paths of adjusted digital signals into one path of digital signal for output.

It can be seen from the above technical solutions that in the present application, an analog signal is output to two branches through a shunt module, different gains are set for the two branches, and a mixing module adjusts amplitudes of digital signals received from the two branches to minimize an amplitude difference between the two paths of digital signals. Thus, it can be ensured that a digital signal output by at least one branch is free from distortion, and the merged digital signal is also free from distortion. In addition, since a distortion-free digital signal can be output without an additional gain adjustment module, the problem is solved that the gain adjustment module takes a certain time to adjust the gain and the signal quality may be poor before the adjustment is completed.

## BRIEF DESCRIPTION OF DRAWINGS

In order to more clearly illustrate the technical solutions in the embodiments of the present application, the drawings required for describing the embodiments will be briefly introduced below. Obviously, the drawings in the following description are only some embodiments of the present application. For those of ordinary skill in the art, other drawings can also be obtained according to these drawings without creative efforts.

FIG. 1 is a schematic diagram of an analog-to-digital conversion device in the related art according to an embodiment of the present application.
FIG. 2 is a schematic diagram of an analog-to-digital conversion device according to an embodiment of the present application.
FIG. 3 is a schematic diagram of another analog-to-digital conversion device in the related art according to an embodiment of the present application.
FIG. 4 is a schematic diagram of another analog-to-digital conversion device according to an embodiment of the present application.
FIG. 5 is a schematic diagram of another analog-to-digital conversion device according to an embodiment of the present application.
FIG. 6 is a schematic diagram of another analog-to-digital conversion device according to an embodiment of the present application.
FIG. 7 is a schematic diagram of another analog-to-digital conversion device according to an embodiment of the present application.
FIG. 8 is a schematic diagram of another analog-to-digital conversion device according to an embodiment of the present application.
FIG. 9 is a schematic diagram of an audio device according to an embodiment of the present application.
FIG. 10 is a schematic diagram of a wireless microphone according to an embodiment of the present application.

## DETAILED DESCRIPTION

FIG. 2 is a schematic diagram of an analog-to-digital conversion device according to an embodiment of the present application. As shown in FIG. 2, the analog-to-digital conversion device may include: a shunt module 20, at least two branches 21 (the first branch 210 and the second branch 211 as shown in the figure), and a mixing module 22; the first branch 210 includes a first gain processing module 2100 and a first analog-to-digital conversion module 2101 connected in cascade, and the second branch 211 includes a second gain processing module 2110 and a second analog-to-digital conversion module 2111 connected in cascade. The working principle of the analog-to-digital conversion device in FIG. 2 can be referred to the following process.

The shunt module 20 splits a received analog signal into two paths of analog signals and outputs the two paths of analog signals to the first branch 210 and the second branch 211 respectively. The first gain processing module 2100 scales a received analog signal according to a first gain and outputs the scaled analog signal to the first analog-to-digital conversion module 2101. The second gain processing module 2110 scales a received analog signal according to a second gain and outputs the scaled analog signal to the second analog-to-digital conversion module 2111. A difference between the first gain and the second gain may be not greater than a first preset value. The first analog-to-digital conversion module 2101 or the second analog-to-digital conversion module 2111 converts a received analog signal after gain processing into a digital signal and outputs the digital signal to the mixing module 22. The mixing module 22 adjusts amplitudes of digital signals received from the first branch 210 and the second branch 211, so that a difference between amplitudes of two paths of adjusted digital signals is not greater than a second preset value, and merges the two paths of adjusted digital signals into one path of digital signal for output.

As an example, the shunt module 20 may split the received analog signal into branch analog signals with the same voltage through voltage division and output the branch analog signals to respective branches.

Each of the first branch 210 and the second branch 211 may include a gain processing module and an analog-to-digital conversion module. The gain processing module of each branch may scale the received analog signal according to a corresponding gain and output the scaled analog signal to the analog-to-digital conversion module in the same branch. The analog-to-digital conversion module of each branch may convert the received analog signal, which has undergone gain processing by the gain processing module in the same branch, into a digital signal and output the digital signal to the mixing module.

In some examples, the gain of the gain processing module with a smaller gain (for example, the first gain) and the first preset value may be determined according to parameters of a device that inputs an analog signal to the analog-to-digital conversion device. Assuming that the maximum input sound pressure level of the device that inputs an analog signal to the analog-to-digital conversion device is 110 dBSPL, it may be pre-specified that when the sound pressure level is 110 dBSPL, the first gain processing module outputs an analog signal of 0 dB after gain processing, that is, the first gain may be -110 dB, so that it can be ensured that the digital signal output by the branch with the smaller gain is free from distortion. At this time, the first preset value may be set based on the value of the above-mentioned maximum input sound pressure level, for example, the first preset value may be set to a value greater than 110 dB, such as 120 dB.

In some examples, after the digital signals input from the first branch 210 and the second branch 211 are received, the mixing module 22 may adjust the amplitudes of the two paths of digital signals, so that a difference between the amplitudes of the two paths of digital signals is not greater than a second preset value, and merge the two paths of adjusted digital signals into one path of digital signal for output. The second preset value may be set according to requirements for the quality of the output signal, for example, the second preset value may be set to 0.0001 dB. Generally, the second preset value is inversely proportional to the quality of the output signal. Specifically, the smaller the second preset value, the closer the amplitude difference between the two digital signals, resulting in better mixing effect and higher quality of the output signal. In addition, the adjustment of the two paths of digital signals by the mixing module 22 may refer to reducing the amplitude of the digital signal output by the branch with the larger gain, so that a difference between the amplitude of the digital signal output by the branch with the larger gain and the amplitude of the digital signal output by the branch with the smaller gain is not greater than the second preset value, thereby ensuring that the merged digital signal is free from distortion.

On one hand, in this embodiment, an analog signal is output to two branches through a shunt module, different gains are set for the two branches, and the mixing module adjusts the amplitudes of the digital signals received from the two branches to minimize the amplitude difference between the two paths of digital signals. Thus, it can be ensured that the digital signal output by at least one branch is free from distortion, and the merged digital signal is also free from distortion. On the other hand, since a distortion-free digital signal can be output without an additional gain adjustment module, the problem is solved that the gain adjustment module takes a certain time to adjust the gain and the signal quality may be poor before the adjustment is completed.

FIG. 3 is a schematic diagram of another analog-to-digital conversion device in the related art according to an embodiment of the present application. As shown in FIG. 3, the analog signal needs to pass through the zero-crossing detection module 13 before being input to the gain adjustment module 12. The zero-crossing detection module 13 inputs the analog signal to the gain adjustment module 12 for gain adjustment only when detecting that the amplitude of the current analog signal crosses zero, that is, the amplitude of the analog signal is relatively small, so as to reduce noise generated during gain adjustment. However, in case where the amplitude of the analog signal is always large, the analog-to-digital conversion device shown in FIG. 3 cannot adjust the gain in a timely manner, which results in poor signal quality before the amplitude of the analog signal crosses zero. Therefore, the applicant has proposed the following solution.

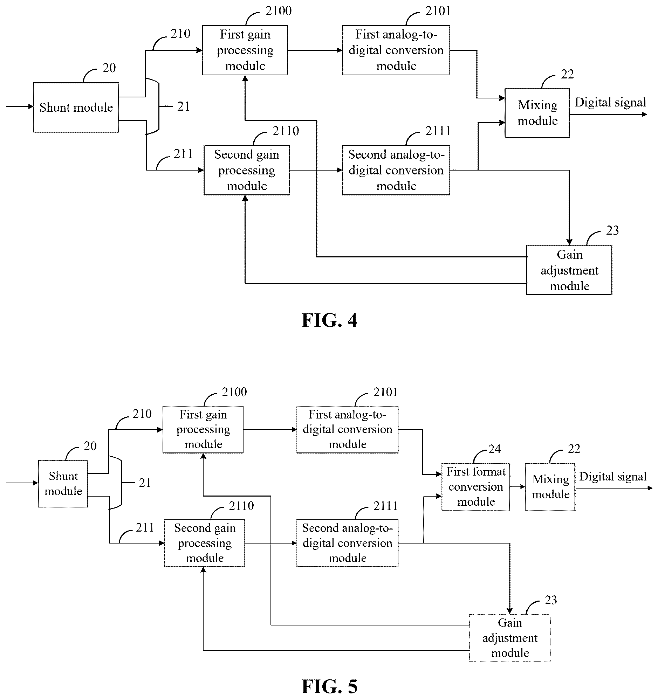

In an embodiment, as shown in FIG. 4, the analog-to-digital conversion device may further include: a gain adjustment module 23, configured to receive a digital signal output by the second analog-to-digital conversion module 2111, determine an adjusted first gain and an adjusted second gain, feed back the adjusted first gain to the first gain processing module 2100, feed back the adjusted second gain to the second gain processing module 2110, and control a speed of adjusting the first gain and the second gain.

The related technology in FIG. 3 can only adjust the gain multiple periodically, and the gain adjustment takes time. Therefore, in order to ensure that the output signal has a certain signal quality, the zero-crossing detection module can only perform zero-crossing detection periodically. The advantage of this embodiment over the traditional technology is that since the mixing module can ensure the high fidelity of the output digital signal, the gain adjustment module 23 can adjust the gain multiples of the two branches at any time without worrying about the distortion of the finally output digital signal. Therefore, the gain adjustment module can be utilized to adjust the gains in real time when the user perceives that the input signal is too large or too small, thereby improving the user experience.

As an example, the gain adjustment module 23 may determine a gain difference of the digital signal output by the second analog-to-digital conversion module 2111 according to the difference between the peak power of the digital signal output by the second analog-to-digital conversion module 2111 and a preset gain. The preset gain may be within a preset gain range.

The gain adjustment module 23 may determine an adjusted second gain of the second analog-to-digital conversion module 2111 according to the gain difference of the digital signal output by the second analog-to-digital conversion module 2111 and an adjustment parameter. The adjustment parameter is configured to control the speed of adjusting the first gain of the first gain processing module 2100 and the second gain of the second gain processing module 2110. Generally, the adjustment parameter is inversely proportional to the gain difference.

The gain adjustment module 23 may determine an adjusted first gain of the first gain processing module 2100 according to the adjusted second gain of the second gain processing module 2110 and the first preset value.

The gain adjustment module 23 may feed back the adjusted first gain to the first gain processing module 2100, and feed back the adjusted second gain to the second gain processing module 2110.

In some examples, the peak power of a digital signal may refer to a value obtained by dividing the square of the maximum amplitude value of the digital signal by 2. The preset gain range may be determined according to the upper gain limit value and the lower gain limit value of the gain processing module. For example, if the upper gain limit value of the gain processing module is 20 dB and the lower gain limit value is 5 dB, the preset gain range may be determined as the interval [5, 20] dB. The preset gain may be set according to actual needs, for example, the preset gain may be 10 dB, which is not limited in the present application.

In some examples, the first preset value may be determined according to the maximum input sound pressure level of the device that inputs an analog signal to the analog-to-digital conversion device and a preset gain. For example, when the maximum input sound pressure level is 110 dBSPL and the preset gain is 10 dB, the first preset value may be set to a value greater than the difference between 110 dB and the preset gain of 10 dB, that is, a value greater than 100 dB, such as 110 dB.

Specifically, the upper gain limit value of the gain processing module can be denoted as $T_H$, and the lower gain limit value can be denoted as $T_L$. The formula for determining the gain difference $\Delta G_1$ of the digital signal according to the difference between the peak power P of the digital signal output by the second analog-to-digital conversion module and the preset gain T may be:

$$\Delta G_1 = P - T, \qquad T \in [T_L, T_H]$$

The formula for determining the gain $G_1'$ of the second analog-to-digital conversion module according to the gain difference $\Delta G_1$ of the digital signal and the adjustment parameter $\alpha$ may be:

$$G_1' = \alpha G_1 + (1 - \alpha)(G_1 - \Delta G_1)$$

$G_1$ may represent the current gain of the second analog-to-digital conversion module.

The formula for determining the gain $G_2'$ of the first conversion module according to the gain $G_1'$ of the second analog-to-digital conversion module and the first preset value $\Delta G$ may be:

$$G_2' = G_1' - \Delta G$$

In each embodiment provided in the present application, the high fidelity of the output digital signal can be ensured, and the applicant has further provided the following improved solution.

In an embodiment, as shown in FIG. 5, the analog-to-digital conversion device may further include:

a first format conversion module 24, which can convert the format of the digital signal output by the first analog-to-digital conversion module 2101 or the second analog-to-digital conversion module 2111 from a fixed-point format to a floating-point format, and output the converted digital signal to the mixing module. The conversion formula may be:

$$y = \frac{x}{Q(m - 1)}$$

where y may represent the value of the digital signal in the floating-point format, x may represent the value of the digital signal in the fixed-point format, m may represent the number of bits used to represent the value of the digital signal in the floating-point format, and $Q(m - 1)$ may represent the maximum value that can be represented by an m-bit signed fixed-point number. The value of m can be determined according to actual needs, for example, the value of m may be 32, 24 or 16, which is not limited in the present application. As an example, if m is 32, the above conversion formula can convert the value of the digital signal in the fixed-point format into the value of the digital signal in the 32-bit floating-point format.

In the related technologies mentioned by the applicant in the present application, such as those illustrated in FIG. 1 and FIG. 3, since the high fidelity of the output digital signal cannot be ensured, the output digital signal is usually not stored or only temporarily stored, and usually only fixed-point storage of the digital signal is required. In this embodiment, on the premise that relatively low distortion can be ensured, the data signal is stored in a floating-point format. Since the digital signal in the floating-point format has a larger dynamic range than the digital signal in the fixed-point format, if the analog-to-digital conversion module quantizes an analog signal into a digital signal in the fixed-point format, the format of the digital signal output by the analog-to-digital conversion module can be converted from the fixed-point format to the floating-point format, and then the converted digital signal is output to the mixing module to adjust the signal amplitude and merge signals, the accuracy and quality of the merged digital signal can be improved.

In some application scenarios, it is necessary to remotely transmit the digital signal output by the mixing module to another device. For example, when the analog-to-digital conversion device is used as a microphone, the digital signal output by the mixing module needs to be transmitted to other devices through a wired or wireless transmission method, so that the user can use a computer to receive and edit an audio file, or merge the audio file with a video file, or connect a headphone for monitoring.

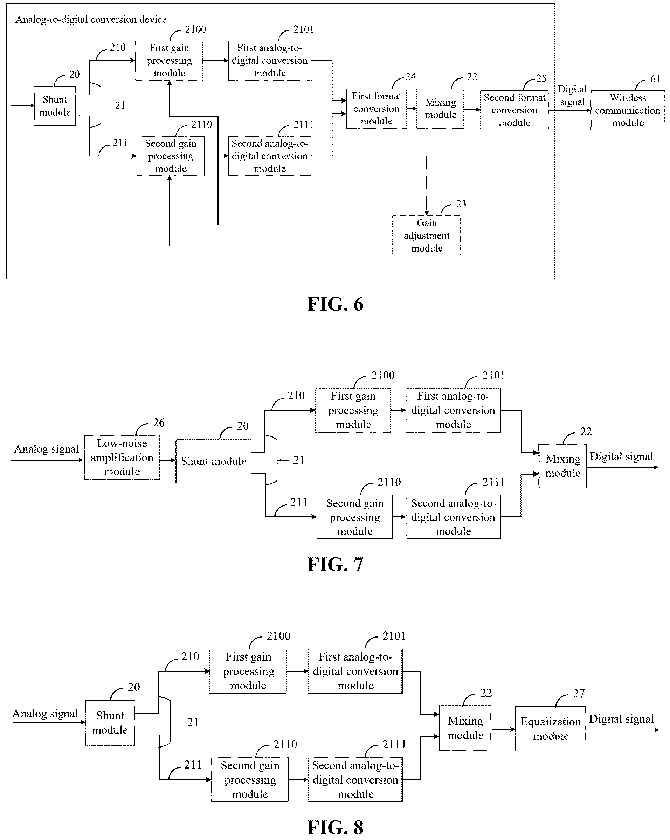

In an embodiment, taking a wireless transmission scenario as an example, as shown in FIG. 6, the analog-to-digital conversion device is connected to a wireless communication module 61, and the analog-to-digital conversion device may further include:

a second format conversion module 25, configured to convert the format of the digital signal output by the mixing module 22 from a floating-point format to a fixed-point format, and then output the converted digital signal to the wireless communication module 61.

In some examples, due to the limited bandwidth of wireless transmission, in order to ensure the efficiency of wirelessly transmitting digital signals, the analog-to-digital conversion device may utilize the second format conversion module to convert the format of the digital signal output by the mixing module from a floating-point format to a fixed-point format, and then transmit the converted digital signal to the wireless communication module, so as to wirelessly transmit the digital signal to other devices.

In an embodiment, as shown in FIG. 7, the analog-to-digital conversion device may further include: a low-noise amplification module 26, configured to perform noise-reduction and amplification processing on the analog signal and then output the processed analog signal to the shunt module.

In some examples, the analog-to-digital conversion device may first perform noise-reduction and amplification processing on the received analog signal through the low-noise amplification module to improve the signal-to-noise ratio of the analog signal, and then output the processed analog signal to the shunt module, which can improve the quality of the signal.

In an embodiment, as shown in FIG. 8, the analog-to-digital conversion device may further include: an equalization module 27, configured to eliminate the direct current (DC) component of the digital signal output by the mixing module through a plurality of filters.

In some examples, the effect of eliminating the DC component of the digital signal can be improved by adopting filters with a high attenuation rate, cascading multiple filters, etc., which is not limited in the present application. In addition, the passband gain of the filters in the equalization module can be set to $-\Delta G$, and the frequency range of the DC component can be 0-20 Hz.

In an embodiment, the mixing module 22, the gain adjustment module 23 or the first format conversion module 24 may be integrated into a programmable logic chip.

The programmable logic chip may include a DSP (Digital Signal Processor), a GPU (Graphics Processing Unit), an NPU (Neural Network Processing Unit), a CPU (Central Processing Unit), etc., which is not specifically limited in the present application.

In an embodiment, the analog-to-digital conversion device may further include: a signal storage module, configured to store the digital signal in the floating-point format output by the mixing module.

In some examples, the digital signal in the floating-point format output by the mixing module can be stored through the signal storage module, so that the user can obtain the digital signal at any time for signal processing, transmission to other devices, and other operations, thereby improving the user experience.

In an embodiment, the analog-to-digital conversion device may further include: a parameter storage module, configured to store parameters in the gain adjustment module.

In some examples, parameters in the gain adjustment module can be stored through the parameter storage module, so that the user can modify the parameters and the gain adjustment module can obtain the parameters. For example, the adjustment parameter $\alpha$ can be stored, so that the gain adjustment module can obtain the adjustment parameter set by the user from the parameter storage module, and adjust the first gain of the first gain processing module and the second gain of the second gain processing module at a speed desired by the user, thereby improving the user experience.

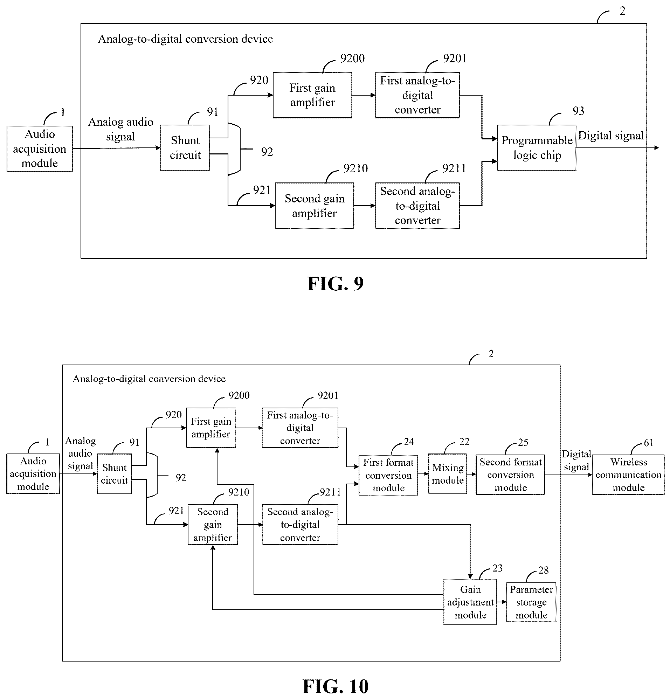

FIG. 9 is a schematic diagram of an audio device according to an embodiment of the present application. As shown in FIG. 9, the audio device may include: an audio acquisition module 1 and an analog-to-digital conversion device 2;

the audio acquisition module 1 outputs an acquired analog audio signal to the analog-to-digital conversion device 2;

the analog-to-digital conversion device 2 includes a shunt circuit 91, at least two branches 92 and a programmable logic chip 93; a first branch 920 includes a first gain amplifier 9200 and a first analog-to-digital converter 9201 connected in cascade, and a second branch 921 includes a second gain amplifier 9210 and a second analog-to-digital converter 9211 connected in cascade;

the shunting circuit 91 is configured to split a received analog signal into two paths of analog signals and output the two paths of analog signals to the first branch 920 and the second branch 921 respectively;

the first gain amplifier 9200 is configured to scale a received analog signal according to a predetermined gain and output the scaled analog signal to the first analog-to-digital converter 9201;

the second gain amplifier 9210 is configured to scale a received analog signal according to a predetermined gain and output the scaled analog signal to the second analog-to-digital converter 9211; where a difference between the first gain and the second gain is not greater than a first preset value;

the first analog-to-digital converter 9201 or the second analog-to-digital converter 9211 is configured to convert a received analog signal after gain processing into a digital signal and output the digital signal to the programmable logic chip 93;

the programmable logic chip 93 is configured to adjust amplitudes of digital signals received from the first branch 920 and the second branch 921, so that a difference between amplitudes of two paths of adjusted digital signals is not greater than a preset value, and merge the two paths of adjusted digital signals into one path of digital signal for output.

In an embodiment, the programmable logic chip 93 may include a mixing module 22, a gain adjustment module (2100, 2110), and a first format conversion module 24. The functions implemented by these modules can be referred to the relevant descriptions in the above embodiments, and will not be repeated here.

In an embodiment, the audio device may further include a wireless transmission module (not shown in the figure). The analog-to-digital conversion device may be connected to a wireless communication module and transmit the digital signal to other devices through the wireless transmission module.

The analog-to-digital conversion device may further include a second format conversion module 25, which converts a format of a digital signal output by the mixing module 22 from a floating-point format to a fixed-point format, and then outputs the converted digital signal to the wireless communication module.

In an embodiment, the audio device may be a wireless microphone.

For a better understanding of the present application, an application example in a specific application scenario is listed herein. In the design of a microphone, considering that users have high requirements for the fidelity of the output sound quality of the microphone, need real-time volume adjustment, and expect to hear high-quality output audio after the volume adjustment, and in addition, users may need to remotely transmit the acquired audio signal by using image transmission technology, this application example provides a technical solution as shown in FIG. 10.

The audio acquisition module 1 acquires an external audio analog signal and inputs the audio analog signal to the shunt circuit 91. The shunt circuit 91 splits the signal into two paths of signals with equal voltage through voltage division and inputs the two paths of signals to the first branch 920 and the second branch 921, respectively. The two paths of signals are amplified by the first gain amplifier 9200 and the second gain amplifier 9210 with different gain multiples. The first analog-to-digital converter 9201 and the second analog-to-digital converter 9211 perform analog-to-digital conversion on the two paths of analog signals, respectively. After that, the first format conversion module 24 converts the output digital signals into floating-point signals and outputs the converted digital signals to the mixing module 22 for merging. The mixing module 22 minimizes the amplitudes of the two paths of digital signals and outputs a digital signal with relatively low distortion.

The gain adjustment module 23 may be an adjustment structure (such as a volume adjustment knob or a volume adjustment button). When a user finds that the input audio analog signal is too large or too small, the gain adjustment module 23 can be adjusted in a timely manner to output a digital signal with an appropriate volume. The parameters in the gain adjustment module 23 can be stored through the parameter storage module 28, and an interactive interface (such as a UI component) can be provided for the user to modify the parameters.

When a user needs to remotely transmit the output digital signal, the second format conversion module 25 converts the digital signal in the floating-point format output by the mixing module 22 into fixed-point data, sends the fixed-point data to the wireless communication module 61, and the wireless communication module 61 transmits the fixed-point data to other receiving devices.

The above descriptions are only preferred embodiments of the present application and are not intended to limit the present application. Any modification, equivalent replacement, improvement, etc. made within the spirit and principle of the present application shall be included in the protection scope of the present application.

## Claims

1.  An analog-to-digital conversion device, comprising a shunt module, at least two branches and a mixing module, wherein a first branch comprises a first gain processing module and a first analog-to-digital conversion module connected in cascade, and a second branch comprises a second gain processing module and a second analog-to-digital conversion module connected in cascade;

    the shunt module is configured to split a received analog signal into two paths of analog signals and output the two paths of analog signals to the first branch and the second branch respectively;
    the first gain processing module is configured to scale a received analog signal according to a first gain and output the scaled analog signal to the first analog-to-digital conversion module;
    the second gain processing module is configured to scale a received analog signal according to a second gain and output the scaled analog signal to the second analog-to-digital conversion module; wherein a difference between the first gain and the second gain is not greater than a first preset value; the first analog-to-digital conversion module or the second analog-to-digital conversion module is configured to convert a received analog signal after gain processing into a digital signal and output the digital signal to the mixing module; and the mixing module is configured to: adjust amplitudes of digital signals received from the first branch and the second branch, so that a difference between amplitudes of two paths of adjusted digital signals is not greater than a second preset value; and merge the two paths of adjusted digital signals into one path of digital signal for output.

2. The analog-to-digital conversion device according to claim 1, further comprising:
a gain adjustment module, configured to receive a digital signal output by the second analog-to-digital conversion module, determine an adjusted first gain and an adjusted second gain, feed back the adjusted first gain to the first gain processing module, feed back the adjusted second gain to the second gain processing module, and control a speed of adjusting the first gain and the second gain.

3. The analog-to-digital conversion device according to claim 1, further comprising:
a first format conversion module, configured to convert a format of the digital signal output by the first analog-to-digital conversion module or the second analog-to-digital conversion module from a fixed-point format to a floating-point format, and output the converted digital signal to the mixing module.

4. The analog-to-digital conversion device according to claim 3, wherein the analog-to-digital conversion device is connected to a wireless communication module, and the analog-to-digital conversion device further comprises:
a second format conversion module, configured to convert a format of a digital signal output by the mixing module from a floating-point format to a fixed-point format, and output the converted digital signal to the wireless communication module.

5. The analog-to-digital conversion device according to claim 1, further comprising:
a low-noise amplification module, configured to perform noise-reduction and amplification processing on an analog signal and output the processed analog signal to the shunt module.

6. The analog-to-digital conversion device according to claim 1, further comprising:
an equalization module, configured to eliminate a direct current component of a digital signal output by the mixing module through a plurality of filters.

7. The analog-to-digital conversion device according to claim 3, wherein the mixing module, the gain adjustment module or the first format conversion module is integrated into a programmable logic chip.

8. An audio device, comprising: an audio acquisition module and an analog-to-digital conversion device;

wherein the audio acquisition module is configured to output an acquired analog audio signal to the analog-to-digital conversion device;
the analog-to-digital conversion device comprises a shunt circuit, at least two branches and a programmable logic chip, wherein a first branch comprises a first gain amplifier and a first analog-to-digital converter connected in cascade, and a second branch comprises a second gain amplifier and a second analog-to-digital converter connected in cascade;
the shunt circuit is configured to split a received analog signal into two paths of analog signals and output the two paths of analog signals to the first branch and the second branch respectively;
the first gain amplifier is configured to scale a received analog signal according to a predetermined gain and output the scaled analog signal to the first analog-to-digital converter;
the second gain amplifier is configured to scale a received analog signal according to a predetermined gain and output the scaled analog signal to the second analog-to-digital converter;
wherein the predetermined gain of the first gain amplifier is different from the predetermined gain of the second gain amplifier;
the first analog-to-digital converter or the second analog-to-digital converter is configured to convert a received analog signal after gain processing into a digital signal and output the digital signal to the programmable logic chip; and
the programmable logic chip is configured to: adjust amplitudes of digital signals received from the first branch and the second branch, so that a difference between amplitudes of two paths of adjusted digital signals is not greater than a preset value; and merge the two paths of adjusted digital signals into one path of digital signal for output.

9. The audio device according to claim 8, wherein the programmable logic chip comprises a mixing module, a gain adjustment module and a first format conversion module;

the mixing module is configured to: adjust amplitudes of digital signals received from the at least two branches, so that a difference between amplitudes of two paths of digital signals is not greater than a preset value; and merge the two paths of adjusted digital signals into one path of digital signal for output;

the gain adjustment module is configured to determine a gain adjustment range for a received digital signal and control a speed at which an adjusted digital signal is output to the first analog-to-digital converter and the second analog-to-digital converter; wherein a gain difference between the adjusted digital signal output to the first analog-to-digital converter and the adjusted digital signal output to the second analog-to-digital converter is the first preset value; and

the first format conversion module is configured to convert a format of a digital signal output by the analog-to-digital converter from a fixed-point format to a floating-point format, and output the converted digital signal to the mixing module.

10. The audio device according to claim 9, wherein the audio device further comprises a wireless transmission module, and the analog-to-digital conversion device is connected to a wireless communication module;

wherein the analog-to-digital conversion device further comprises: a second format conversion module, configured to convert a format of a digital signal output by the mixing module from a floating-point format to a fixed-point format, and output the converted digital signal to the wireless communication module.

11. The audio device according to claim 10, wherein the audio device is a wireless microphone.

Clock signal → [Gain adjustment module] — 12

Gain adjustment module

Analog signal → [Gain processing module] — 10 → [Analog-to-digital conversion module] — 11 → Digital signal

**FIG. 1**

Analog signal → [Shunt module] — 20 — 21

First gain processing module — 2100 → First analog-to-digital conversion module — 2101

Second gain processing module — 2110 → Second analog-to-digital conversion module — 2111

→ [Mixing module] — 22 → Digital signal

210
211

**FIG. 2**

[Zero-crossing detection module] — 13 → [Gain adjustment module] — 12

Analog signal → [Gain processing module] — 10 → [Analog-to-digital conversion module] — 11 → Digital signal

**FIG. 3**

**FIG. 4**

**FIG. 5**

**FIG. 6**

**FIG. 7**

**FIG. 8**

**FIG. 9**

**FIG. 10**

## INTERNATIONAL SEARCH REPORT

| International application No. |
| --- |
| **PCT/CN2024/091035** |

| A. | CLASSIFICATION OF SUBJECT MATTER |
| --- | --- |
| | H03M1/18(2006.01)i |

According to International Patent Classification (IPC) or to both national classification and IPC

| B. | FIELDS SEARCHED |
| --- | --- |

Minimum documentation searched (classification system followed by classification symbols)

IPC:H03M

Documentation searched other than minimum documentation to the extent that such documents are included in the fields searched

Electronic data base consulted during the international search (name of data base and, where practicable, search terms used)

CNABS, CNTXT, VEN, USTXT, CNKI, IEEE: 分流, 模数转换, 支路, 增益, 混音, 融合, 合并, 定点, 浮点, 降噪, 音频, audio, split, branch, ADC, gain, mix, fuse, fixed, float, noise reduction

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 113079440 A (GUANGDONG OPPO MOBILE TELECOMMUNICATIONS CORP., LTD.) 06 July 2021 (2021-07-06) <br> description, paragraphs 30-55, and figure 2 | 1-11 |
| A | CN 101895266 A (SHANGHAI ANYWAVE COMMUNICATION TECHNOLOGIES CO., LTD.) 24 November 2010 (2010-11-24) <br> entire document | 1-11 |
| A | CN 104954036 A (GUANGZHOU RUNXIN INFORMATION TECHNOLOGY CO., LTD.) 30 September 2015 (2015-09-30) <br> entire document | 1-11 |
| A | CN 105702264 A (NUBIA TECHNOLOGY CO., LTD.) 22 June 2016 (2016-06-22) <br> entire document | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **17 December 2024** | **23 December 2024** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

### INTERNATIONAL SEARCH REPORT
Information on patent family members

International application No.

**PCT/CN2024/091035**

| Patent document cited in search report | | | Publication date (day/month/year) | Patent family member(s) | | | Publication date (day/month/year) |
|---|---|---|---|---|---|---|---|
| CN | 113079440 | A | 06 July 2021 | WO | 2022199288 | A1 | 29 September 2022 |
| CN | 101895266 | A | 24 November 2010 | None | | | |
| CN | 104954036 | A | 30 September 2015 | None | | | |
| CN | 105702264 | A | 22 June 2016 | WO | 2017113946 | A1 | 06 July 2017 |

Form PCT/ISA/210 (patent family annex) (July 2022)